# EUROPEAN PATENT APPLICATION

(11) **EP 4 844 787 A1**
(43) Date of publication of application: **25.11.2026**
(21) Application number: 25275038.5
(22) Date of filing: 23.05.2025
(51) Int. Cl.: H01F 6/06, G01R 33/3815, H01F 41/04

(54) **MAGNET ARRANGEMENT, METHOD OF MANUFACTURING, AND MAGNETIC RESONANCE DEVICE WITH TOROIDALLY WOUND SUPERCONDUCTING TAPE**

(71) Applicant: Siemens Healthcare Limited, Camberley, Surrey GU15 3YL (GB)
(72) Inventor: Mallett, Michael, Faringdon, SN7 8EL (GB)
(74) Representative: Siemens Healthineers Patent Attorneys

(57) **Abstract**

The invention relates to a magnet arrangement (11), comprising: a magnet coil (30) including a tape (32) comprising a superconducting material, wherein the tape (32) is wound into a toroidal structure (44), and wherein an angle between a direction of a magnetic field generated by the magnet coil (30) and a main surface (37) of the tape (32) is substantially constant throughout the toroidal structure (44). The current invention further concerns a method of manufacturing a magnet arrangement (11) and a magnetic resonance device (10) comprising an inventive magnet arrangement (11).

## Description

The current invention concerns a magnet arrangement, a method of manufacturing a magnet arrangement, and a magnetic resonance device.

Independent of the grammatical term usage, individuals with male, female or other gender identities are included within the term.

High-temperature superconducting (HTS) materials have gained significant attention for use in magnet coils due to their ability to carry high current densities at relatively high temperatures compared to conventional low-temperature superconductors. HTS materials are typically manufactured in the form of thin tapes with a high aspect ratio, where the width of the tape is much larger than its thickness. These tapes are commonly wound into cylindrical coils using single pancake or double pancake configurations, where the tape is wound on top of itself in a radial direction to create a coil with one or two rows and multiple turns.

The performance of superconducting tapes can be sensitive to the angle of the magnetic field they experience. For example, the current carrying capability of some HTS materials is highest when the magnetic field is parallel to the tape surface and lowest when the field is perpendicular to the surface. In conventional magnet designs using HTS tapes, this angular dependence typically leads to inefficient use of the superconducting material. Magnet designs often need to account for the worst-case magnetic field angle, resulting in conservative designs that may not fully utilize the potential of the superconducting tape throughout an entire magnet arrangement.

It has been appreciated that a magnet arrangement is needed that overcomes one or more of these problems.

Hence, it is an object of the current invention to provide a magnet arrangement that allows for a more efficient use of superconducting tape in comparison to conventional magnet designs.

This object is achieved by a magnet arrangement, a magnetic resonance device and a method of manufacturing a magnet arrangement according to the invention. Further advantageous embodiments are specified in the dependent claims.

In a first aspect, the invention concerns a magnet arrangement. The magnet arrangement comprises a magnet coil including a tape comprising a superconducting material. The tape is wound into a toroidal structure. An angle between a direction of a magnetic field generated by the magnet coil and a main surface of the tape is substantially constant throughout the toroidal structure when the magnet coil is in an operating state.

A magnet arrangement may comprise one or more magnetic components arranged in a specific configuration to generate a magnetic field. For example, the magnet arrangement may comprise one or more magnet coils, but also a support structure for the magnet coils. The magnet arrangement can be configured to provide a static magnetic field for applications such as magnetic resonance imaging, particle accelerators, or scientific instruments.

A magnet coil can be configured as a component of the magnet arrangement. The magnet coil may comprise one or more windings of an electrically conductive material. The magnet coil can be configured to generate a magnetic field when an electric current flows through the one or more windings. The windings of the magnet coil may comprise a superconducting material to enable the generation of magnetic fields with minimal power loss. For example, the one or more windings may comprise or consist of a tape comprising a superconducting material.

The magnet coil may comprise a toroidal shape. For example, the magnet coil may comprise the shape of a ring torus or a solid torus. In the latter case, the tape may be wound around a former or support structure that fills or makes up at least a part of a circular cross-section of an imaginary circle that revolves around a major axis defining the toroidal structure.

According to an embodiment, the magnet coil is configured to generate a magnetic field suitable for use in a magnetic resonance imaging application. The magnet coil can be configured to provide a static or main magnetic field within an imaging region of a magnetic resonance device. For example, the magnet arrangement comprising the magnet coil can be configured to generate a main magnetic field having a maximum magnetic field strength between 0.1 and 9 Tesla, for example about 0.5 Tesla, 1.5 Tesla, 3 Tesla, or 7 Tesla.

A tape can be configured as a thin, flat strip or band. The tape can have a high aspect ratio, with a width significantly greater than its thickness. A length of the tape may far exceed the width of the tape. For example, the length of the tape can be in the order of meters, while the width of the tape can be in the order of millimetres or centimetres.

The tape may comprise or consist of a superconducting material. According to an embodiment, the tape comprises a superconducting material deposited on a substrate. The superconducting material may exhibit negligible electrical resistance at or below a superconducting temperature. The tape may comprise a high-temperature superconducting (HTS) material or, in some cases, a low-temperature superconducting (LTS) material.

A superconducting material may represent a material that exhibits substantially zero electrical resistance when cooled below a certain critical temperature (or superconducting temperature). Examples of superconducting materials can include low-temperature superconductors such as niobium-titanium alloys, or high-temperature superconductors such as yttrium barium copper oxide (YBCO) compounds.

A toroidal structure may comprise a three-dimensional geometric shape resembling a donut, a ring, or a circular hollow tube. The toroidal structure may comprise a minor axis and a major axis. The minor axis of the toroidal structure may be understood as a circular axis defined by a trajectory of a geometric centre of an imaginary circle revolving around a major axis of the toroidal structure to represent the toroidal structure. The major axis of the toroidal structure may represent an axis of rotational symmetry, around which the imaginary circle representing the toroidal structure revolves. In the context of the present invention, the toroidal structure can be formed by winding the tape around a minor axis of the toroidal structure.

The tape of the inventive magnet may be wound in the shape of a toroidal structure. The expression of a "tape wound into a toroidal structure" may be understood in such a way that the tape is wound onto or arranged on an outer surface of the toroidal structure or torus. The wound tape itself may comprise the shape of a toroidal structure or torus. For example, a tape wound into a toroidal structure may exhibit the shape of a ring torus or hollow torus. The tape may be wound in such a way, that a main surface of the tape is wound onto or arranged on an outer surface of the toroidal structure.

An operating state of a magnet coil may refer to a condition in which the magnet coil is actively generating a magnetic field. For example, an operating state ofg the magnet coil may be characterized by an electric current running through the tape of the magnet coil.

A direction of a magnetic field may be characterized by an orientation of magnetic field lines in three-dimensional space. The direction of the magnetic field can be represented by magnetic field vectors pointing from a north pole to a south pole of a magnet or magnet coil. The direction of the magnetic field may vary locally along a surface of the magnet coil. In the context of the present invention, the direction of the magnetic field may refer to the local direction of the magnetic field at a surface of the magnet coil, particularly a main surface of the tape.

A main surface of the tape may correspond to a surface of the tape having the largest surface area. For example, the main surface of the tape can be defined by the product of the width and the length of the tape. The tape may comprise two main surfaces facing in opposite spatial directions (e. g. an inner main surface and an outer main surface).

The phrase "substantially constant throughout the toroidal structure" can be understood to mean that a particular property or characteristic remains approximately the same or varies only minimally across the entire toroidal structure. For example, the angle between the direction of the magnetic field and the main surface of the tape may be understood to remain nearly uniform throughout the winding of the toroidal coil. Particularly, the tape may be wound in such a way that the angle between the local direction of the magnetic field and the main surface of the tape at the interface between the magnetic field and the main surface of the tape is nearly constant along the length of the tape.

According to an embodiment, the inventive magnet arrangement comprises a plurality of magnet coils. Each magnet coil of the plurality of magnet coils may comprises a tape wound into a toroidal structure. The plurality of magnet coils may be configured to generate a magnetic field. The magnet arrangement may be configured in such a way that an angle between a direction of a magnetic field generated by the magnet arrangement and a main surface of the tape is substantially constant throughout the toroidal structure when the magnet arrangement is in an operating state.

A superconducting tape wound into a toroidal shape or toroidal structure may enable the angle between the direction of the magnetic field generated by the magnet coil, but also the magnet arrangement, and the main surface of the tape to be substantially constant throughout the toroidal structure. A tape wound into a toroidal shape or toroidal structure may be characterized in that surface normal vectors along a main surface of the tape rotate around a minor axis of the toroidal structure.

A superconducting tape wound into a toroidal shape or toroidal configuration may allow for an efficient use of the superconducting tape, as the performance of superconducting materials may depend on the direction of the magnetic field they experience.

The magnet arrangement can be configured as part of a magnetic resonance device or other device.

An inventive magnet arrangement may favourably allow for a compact design while potentially optimizing the performance of the tape by maintaining a predefined magnetic field angle relative to the main surfaces of the tape throughout the toroidal structure. The inventive magnet arrangement may allow for a more efficient use of the superconducting material and potentially reduce the amount of superconducting material required for a given magnetic field strength, which can result in cost savings and/or improved performance of the magnet arrangement.

According to an embodiment of the inventive magnet arrangement, the tape is helically wound around a minor axis of the toroidal structure.

The term "winding" may be understood as the process of wrapping or coiling the tape around an axis of the toroidal structure. The process of winding the tape can result in the tape being wound into a specific pattern and/or shape, such as the shape of a toroidal structure. In some embodiments, the wound tape may comprise multiple layers and/or turns of the tape around the minor axis, but also the major axis, of the toroidal structure.

The tape may be wound in a helical winding pattern. The helical winding pattern may require that the tape follows a helical or spiral path around the minor axis as it forms the toroidal structure. The minor axis of the toroidal structure may represent a circular path around which the tape is wound. Furthermore, the minor axis may represent an axis of rotation for the helical winding of the tape. The helical winding pattern may facilitate maintaining a substantially constant angle between the main surface of the tape and the direction of the magnetic field generated by the magnet coil or magnet arrangement throughout the toroidal structure.

The tape may be helically wound around the minor axis, but also the major axis, of the toroidal structure. The minor axis can be oriented perpendicular to the major axis of the toroidal structure. According to an embodiment, the helical winding pattern is characterized by the tape making multiple revolutions around the minor axis while simultaneously progressing along a circumference of the toroidal structure. This winding technique can result in the tape forming one or more loops or coils that encircle the minor axis over the circumference of the toroidal structure. In case the tape forms a plurality of loops around the major axis, or the magnet coil comprises a plurality of separate tapes forming loops around the major axis, the loops may be separated or distanced from each other by a gap.

A pitch or winding angle of the helical winding pattern can be adjusted to optimize the magnetic field characteristics. For example, a smaller pitch can result in more closely spaced tapes, potentially increasing the magnetic field strength, while a larger pitch may allow for improved cooling and/or reduced risk of quenching.

The helical winding pattern can be implemented using various winding techniques. For example, the tape can be wound onto a former or a support structure that has been pre-shaped into a toroidal form. Alternatively, the tape can be wound directly into a toroidal shape using specialized winding equipment designed for this purpose.

A magnet coil comprising a tape which is helically wound around the minor axis of a toroidal structure may provide several advantages. For example, the helical winding pattern may allow for a more uniform distribution of the magnetic field provided within a volume enclosed by the toroidal structure or magnet coil. Moreover, the helical winding pattern can allow for a more compact design compared to traditional solenoidal or pancake coil configurations, potentially reducing the overall size and weight of the magnet arrangement. Furthermore, the helical winding pattern may facilitate cooling of the superconducting material in the tape, as it can allow for better access of cooling fluids and/or conduction paths to all sections of the tape.

In a further embodiment of the inventive magnet arrangement, the tape is wound in such a way that the direction of the magnetic field generated by the magnet coil or magnet arrangement is oriented substantially in parallel to the main surface of the tape throughout the toroidal structure.

For example, the tape may be wound in such a way that a surface normal vector of the main surface of the tape is essentially orthogonal to a tangent to a surface of the toroidal structure at an origin of the surface normal vector. A surface normal vector of a main surface of the tape may represent a vector which is oriented perpendicular to the main surface of the tape at a given point. A tangent to a surface of a toroidal structure may represent a line that touches an outer surface of the toroidal structure at a single point without intersecting it. A tangent to a surface of a toroidal structure at an origin of the surface normal vector may touch the outer surface of the toroidal structure at the origin of the surface normal vector or close to the origin of the surface normal vector.

The term "essentially orthogonal" may be understood as forming an angle of approximately 90 degrees, with only minor deviations allowed. Minor deviations may result from manufacturing tolerances and/or slight variations in the winding process. For example, the angle between the surface normal vector of the main surface of the tape and the tangent to the surface of the toroidal structure at the origin of the surface normal vector may deviate from a 90-degrees angle by less than 1 degree, less than 2 degrees, five degrees, or less than ten degrees, depending on the specific requirements of the magnet arrangement and the precision of a winding apparatus used to wind the tape into the toroidal structure. Likewise, an angle between the local direction of the magnetic field and the main surface of the tape may deviate from a zero-degree angle (i. e. a parallel relationship) by less than 10 degrees, less than 5 degrees, less than 2 degrees, or less than one degree throughout the toroidal structure.

According to an embodiment, the tape is arranged or wound in such a way that a plurality or all surface normal vectors of the main surface of the tape are essentially orthogonal to tangents to a surface of the toroidal structure at the origins of the respective surface normal vectors.

An inventive arrangement or winding pattern of the tape may allow maintaining a substantially constant angle between the direction of the magnetic field generated by the magnet coil or magnet arrangement and the main surface of the tape throughout the toroidal structure. By arranging the tape such that the main surface of the tape is substantially parallel to the local direction of the magnetic field generated by the magnet coil or magnet arrangement, the tape can follow the curvature of the toroidal structure while maintaining a beneficial or optimized orientation relative to the direction of the magnetic field generated by the magnet coil or magnet arrangement.

In one aspect, the invention may relate to a winding apparatus configured to continuously adjust the orientation and/or axial tilt (e. g. a tilt around a centreline of the tape) of the tape as it is wound around the toroidal structure. The winding apparatus can comprise a tape feed mechanism, a positioning system, and a control unit. The control may be configured to calculate or determine the required orientation and/or axial tilt of the tape at each point along the toroidal structure and direct the positioning system to adjust the tape feed mechanism accordingly.

An inventive magnet arrangement may favourably enable an improved utilization of the material properties of the tape. Superconducting materials often exhibit anisotropic behaviour, meaning their performance can vary depending on the orientation of the magnetic field relative to their crystalline structure. By maintaining an appropriate, consistent orientation relative to the magnetic field, the tape can operate at its maximum current-carrying capacity throughout the entire magnet coil.

In certain embodiments, a crystal growth axis of the superconducting material of the tape may deviate from a surface normal vector of the main surface of the tape. For example, the crystal growth axis may be oriented at a non-zero or non-parallel angle with respect to the surface normal vector of the main surface of the tape at one or more points along the main surface of the tape. In such cases, the tape may be wound in such a way that the direction of the magnetic field generated by the magnet coil or magnet arrangement is oriented substantially in parallel to the crystal growth axis of the superconducting material of the tape throughout the toroidal structure. The "crystal growth axis" may refer to a direction along which crystals of the superconducting material in the tape grow. The crystal growth axis or crystal growth direction of the superconducting material may influence the properties of the superconducting material of the tape.

A tape wound in such a way that the direction of the magnetic field generated by the magnet coil or magnet arrangement is oriented substantially in parallel to the main surface of the tape throughout the toroidal structure can contribute to a more uniform magnetic field distribution within the magnet arrangement. A consistent orientation of the tape relative to the direction of the magnetic field may provide a more predictable and/or controllable field pattern, which can be particularly beneficial in applications requiring high field homogeneity, such as magnetic resonance imaging. Furthermore, the inventive magnet arrangement can potentially reduce mechanical stress on the tape. By aligning the tape with the curvature of the toroidal structure, bending and torsional stresses on the tape can favourably be minimized, potentially increasing the longevity and reliability of the magnet coil.

According to an embodiment of the inventive magnet arrangement, the magnet arrangement comprises at least one further tape.

The at least one further tape can be wound into the toroidal structure in a similar manner as the tape. This can involve following the same winding pattern, maintaining consistent spacing between the tape and the at least one further tape, and/or ensuring proper alignment between the tape and the at least one further tape within the toroidal structure, but also ensuring a substantially parallel orientation of the main surface of the at least one further tape with respect to the direction of the magnetic field generated by the magnet coil or magnet arrangement throughout the toroidal structure.

The at least one further tape can be arranged adjacent to or spaced apart from the tape. The at least one further tape may be configured to increase the overall current capacity of the magnet coil. The at least one further tape can be electrically connected in series or in parallel with the tape. A series connection may facilitate manufacturing of the magnet coil, while a parallel connection can enable higher current capacity. Electrical connections between tapes can be made at the inner and/or outer surfaces of the toroidal structure (e. g. a surface facing towards the major axis and/or a surface facing away from the major axis of the toroidal structure).

The magnet arrangement may comprise a former configured to provide structural support for the magnet coil. For example, the tape may be wound around the former in a toroidal configuration. The at least one further tape can be wound around the same former as the tape or around a separate former. The at least one further tape can be made of the same superconducting material as the tape or a different superconducting material.

The at least one further tape can be configured as an additional or separate superconducting tape that is wound into the toroidal structure alongside the tape. The at least one further tape can be arranged parallel to and/or spaced apart from the tape within the toroidal structure. It is conceivable that the at least one further tape is arranged adjacent to or concentric with the tape within the magnet coil. The at least one further tape can be wound in such a way that the at least one further tape and the tape are arranged or wound equidistant or non-equidistant to each other. The at least one further tape and the tape may be wound with overlap or without overlap. Furthermore, a section of the at least one further tape and a section of the tape may be arranged at the same distance or at different distances with respect to a minor axis and/or a major axis of the toroidal structure.

The tape and the at least one further tape can be configured as thin, flat strips or bands. The tape and the at least one further tape may comprise a substrate coated with one or more layers of superconducting material. The tape and the at least one further tape can have a high aspect ratio, with the width substantially exceeding the thickness.

In one embodiment, multiple tapes are wound in parallel to form the magnet coil, with each tape following a helical path around the minor axis of the toroidal structure according to an embodiment described above.

The at least one further tape can be wound in the same direction as the tape, or in an opposite direction. Winding multiple tapes in parallel can enable higher current capacity for the magnet coil.

Gaps may be provided between the tape and the at least one further tape to reduce the risk of quench propagation between tapes. The gaps may also be configured to provide space for routing electrical connections, cooling connections, support elements and/or instrumentation.

According to an embodiment, an angle between a direction of a magnetic field generated by the magnet coil or magnet arrangement and a main surface of the at least one further tape is substantially constant throughout the toroidal structure. The at least one further tape may be wound in such a way that the direction of the magnetic field generated by the magnet coil or magnet arrangement is oriented substantially in parallel to the main surface of the at least one further tape throughout the toroidal structure. This can be achieved, for example, by winding the at least one further tape with a similar helical pattern around the minor axis of the toroidal structure as the tape.

Incorporating multiple tapes wound into the toroidal structure may favourably increase the overall current capacity and/or magnetic field strength of the magnet arrangement while ensuring an efficient use of the superconducting material of each individual tape.

According to a further embodiment, the inventive magnet arrangement comprises a former configured to provide structural support for the magnet coil.

The former can be configured as a support structure or framework on which the tape is wound to form the toroidal structure of the magnet coil. The former can comprise a rigid material such as a metal, alloy, polymer, or composite material. Examples of suitable materials for the former include aluminium, stainless steel, fiberglass-reinforced plastic, carbon fibre composites, and the like. The former may also comprise or consist of a material having a high thermal conductivity to help distribute cooling throughout the magnet coil.

The former may comprise a toroidal shape. The shape of the former may define the overall geometry of the magnet coil. The former can be configured to maintain the toroidal structure of the magnet coil and provide a stable base for winding the tape.

The magnet coil including the former may comprise the shape of a solid toroid or a solid torus. This shape can allow for a compact design while improving or optimizing the performance of the tape in comparison to conventional solutions by maintaining a favourable angle between the main surfaces of the tape and the direction of the magnetic field generated by the magnet coil or magnet arrangement according to an embodiment described above.

According to an embodiment, the former comprises grooves, channels, receiving surfaces or other features on its surface to guide and secure the tape as it is wound. The former can be configured to maintain a desired spacing and/or alignment between windings or turns of the tape, but also between windings of separate tapes.

In a further embodiment, the former is configured to aid in thermal management of the magnet coil. For example, the former can comprise channels and/or cavities for circulating a coolant or cryogen. A channel or cavity in the former for circulating a coolant or cryogen may favourably allow for precooling, but also maintaining the superconducting state, of the tape.

According to an embodiment, the former comprises and/or forms a part of a precooling circuit. The precooling circuit may be configured to enable the magnet coil to be subjected to accelerated cool down. For example, the precooling circuit may allow for the magnet coil to reach its superconducting temperature faster in comparison to the use of conventional refrigeration means alone. The former may comprise cooling channels or cooling pipes configured to transport a coolant or precooling fluid, which can be circulated through the former during an initial cool-down phase.

The former can be configured as a single integrated or monolithic piece or can comprise multiple sections that are assembled together. The former may comprise mounting points or interfaces to secure the magnet coil within a larger support structure (e. g. a magnet support structure) or cryostat structure.

The former may be configured to resist electromagnetic forces generated during operation of a device comprising the inventive magnet arrangement. For example, the former may be configured to maintain a geometry and/or shape of the magnet coil under thermal and/or magnetic cycling (e. g. in the case of varying temperatures or magnetic fields). The former may also be configured to provide rigidity to the magnet arrangement. According to an embodiment, the former is configured to maintain the toroidal shape and tape winding pattern of the magnet coil necessary for generating a desired magnetic field.

The former can comprise or consist of various materials selected for their structural properties and/or compatibility with cryogenic environments. For example, the former can be made from aluminium, which offers a good balance of strength, weight, and thermal conductivity. Stainless steel can also be used as a material for the former, providing excellent strength and corrosion resistance. In some embodiments, the former may comprise a composite material, such as glass-reinforced plastic (GRP), which can offer advantages in terms of weight reduction and thermal insulation.

Moreover, the former can comprise a material with a high heat capacity. A material having a high heat capacity may ensure that the magnet coil remains cold for an extended period of time if the cooling system fails or is temporarily switched off. Materials with high heat capacity can act as thermal buffers, absorbing and/or releasing heat slowly and helping to maintain a stable temperature environment for the tape. For example, the former can comprise or consist of aluminium or stainless steel.

The former may comprise features such as grooves, channels, or receiving surfaces configured to facilitate the winding process and/or ensure precise positioning of the tape, but also at least one further tape. These features can be machined or moulded into a surface of the former, creating dedicated paths for the tape to follow during the winding process. The grooves, channels, or receiving surfaces can be designed to match the dimensions of the tape, ensuring a snug fit and minimizing the risk of tape displacement during winding and/or operation of the device comprising the inventive magnet arrangement.

An inventive magnet arrangement comprising a former according to an embodiment described above may offer several advantages. For example, the former may provide a robust and stable platform for winding the tape, ensuring that the shape of the toroidal structure is maintained throughout the operational life of the magnet coil. Furthermore, the incorporation of cooling features within the former may allow for a more rapid cool-down process, potentially reducing the time required to bring the magnet to its operational temperature. Moreover, the use of materials with high heat capacity in the former can enhance the thermal stability of the magnet arrangement, providing a safeguard against temporary cooling system failures and contributing to the overall reliability of the magnet arrangement.

In a further embodiment of the inventive magnet arrangement, the former is configured to accommodate a cooling fluid to cool the magnet coil. Additionally or alternatively, the former can be thermally and mechanically connected to a cooling system via a solid thermal conductor.

The former can be configured to accommodate a cooling fluid in various ways. For example, the former can comprise one or more cooling channels configured to transport a cooling fluid or coolant, such as a liquid and/or a gas. The cooling fluid can be circulated through the cooling channels of the former by a cooling system. According to an embodiment, the magnet arrangement comprises a cooling system configured to circulate the cooling fluid through a section of the former, for example through a channel or a pipe incorporated within the former.

Alternatively or additionally, the former can be thermally and mechanically connected to a cooling system via a solid thermal conductor. Thus, the former can be cooled partially or entirely via thermal conduction. The solid thermal conductor can comprise or consist of a material with high thermal conductivity, such as a metal (e. g. aluminium, copper, silver, gold, or the like), particularly a high-purity metal. The solid thermal conductor can comprise any suitable shape. For example, the solid thermal conductor may comprise a metal conductor in the shape of a braid, a rod, a plate, a mesh, a rail, or a combination thereof.

The former may comprise or form a part of a precooling circuit according to an embodiment described above.

The former can comprise a cooling channel configured to transport a cooling fluid, such as a cryogen. The cooling channel can be integrated within the former. The cooling fluid can be circulated through the cooling channel via a cooling system. The cooling system may comprise a cryocooler used in cryogenic applications. The cryocooler can comprise a cold head with one or more cooling stages. In case the cold head comprises multiple cooling stages, each cooling stage can have a different temperature level. For example, the cold head of the cryocooler can comprise a first stage and a second stage. The second stage can be thermally and mechanically connected to the magnet coil. The first stage can be thermally and mechanically connected to a component of the magnet arrangement (or device comprising the magnet arrangement) different from the magnet coil. A temperature level of the first stage can exceed a temperature level of the second stage. For example, the first stage can be configured to provide a temperature in the range between 30 K to 180 K, preferably in the range between 30 K to 60 K, 60 K to 100 K, or 100 K to 180 K. The second stage can be configured to provide a temperature level close to the superconducting temperature of the tape.

According to an embodiment, the tape is at least partially embedded within the former. For example, the former may comprise grooves, channels or receiving surfaces into which the tape is wound. The grooves, channels or receiving surfaces can be shaped to accommodate the tape and maintain its desired arrangement and/or orientation within the toroidal structure. The receiving surfaces can be formed as grooves, recesses or depressions in an outer surface of the former. However, the receiving surfaces can also protrude or be raised from the outer surface of the former.

A magnet arrangement comprising a former connected to a cooling system may provide several advantages. For example, the former may enable efficient cooling of the magnet coil but also maintaining the superconducting state of the tape. A former comprising a material having a high heat capacity may favourably improve thermal inertia, buffering temperature fluctuations and/or allowing the magnet coil to remain cold for an extended period if the cooling system is temporarily interrupted. A former comprising and/or forming a part of a precooling circuit may allow for rapid and/or uniform cooling of the magnet coil. A former thermally and mechanically connected to a cooling system via a solid thermal conductor may allow for a reduction of an amount of cryogen required to cool the magnet coil, but also an omission of fluid connections.

According to a further embodiment of the inventive magnet arrangement, the tape comprises a high-temperature superconducting material. For example, the tape can comprise a rare earth barium copper oxide (REBCO) material.

A high-temperature superconducting material may exhibit superconductivity at temperatures above 30 K, 40 K, 50 K, 60 K, 70 K, 80 K, or 90 K. For example, a high-temperature superconducting material may exhibit superconductivity at temperatures above the boiling point of liquid nitrogen (77 K or -196° C). The use of high-temperature superconducting materials may allow for coolants or cryogens to be used that are more cost-effective and/or easier to handle compared to liquid helium, which is conventionally used for cooling of low-temperature superconductors.

High-temperature superconducting materials may include various ceramic compounds, such as yttrium barium copper oxide (YBCO) or bismuth strontium calcium copper oxide (BSCCO). These materials can be configured to maintain substantially zero electrical resistance and provide magnetic fields at relatively high temperatures compared to conventional or low-temperature superconductors.

A rare earth barium copper oxide (REBCO) material may represent a specific type of high-temperature superconducting material. REBCO materials can be configured to include compounds where a rare earth element (such as yttrium, gadolinium, or samarium) is combined with barium and copper oxide. For example, REBCO materials may represent a family of ceramic compounds with the general formula REBa₂Cu₃O₇₋ₓ, where RE represents a rare earth element such as yttrium (Y), gadolinium (Gd), or samarium (Sm).

According to an alternative embodiment, the magnet arrangement may comprise a tape that comprises a low-temperature superconducting material instead of a high-temperature superconducting material. A low-temperature superconducting material can be configured as a material that exhibits superconductivity at a temperature below 30 K (-243° C). Examples of low-temperature superconducting materials can include niobium-titanium (NbTi) and niobium-tin (Nb3Sn).

The high-temperature superconducting material of the tape can be configured as a thin film deposited on a substrate. The substrate can be configured to provide mechanical support and can comprise materials such as stainless steel, corrosion resistant alloys (e. g. comprising nickel, but also cobalt, chromium, molybdenum, tungsten, iron, manganese, and the like), or sapphire.

In addition, the tape can comprise buffer layers between the substrate and the high-temperature superconducting material. These buffer layers can be configured to prevent diffusion of elements from the substrate into the superconducting material and/or to provide a suitable crystal structure for the growth of the high-temperature superconducting material.

The tape can further comprise a protective layer covering the high-temperature superconducting material. This protective layer can be configured to prevent degradation of the superconducting material due to environmental factors such as moisture and/or mechanical stress.

The use of a high-temperature superconducting material, such as REBCO, in the tape of the magnet arrangement may favourably allow for higher operating temperatures of the magnet coil, enabling the use of more efficient and/or less costly cooling systems.

In a further embodiment, the inventive magnet arrangement comprises a plurality of magnet coils stacked along a major axis of the toroidal structure. Each magnet coil of the plurality of magnet coils can be configured in accordance with a previously described embodiment of the magnet coil.

The magnet arrangement may comprise multiple magnet coils arranged in a stack formation. The plurality of magnet coils can be arranged along the major axis of the toroidal structure. For example, the plurality of magnet coils can be arranged concentrically along the major axis of the toroidal structure. The major axis may represent an axis of rotational symmetry for the toroidal structure. Each magnet coil of the plurality of magnet coils may be configured in accordance with an embodiment of a magnet coil described herein. The magnet coils of the plurality of magnet coils may have the same or different dimensions. For example, the magnet coils of the plurality of magnet coils may have the same or different diameters, lengths, number of turns of the tape, winding patterns, or the like. One or more magnet coils may be configured as outer coils or shield coils. One or more magnet coils may be configured as inner coils or coils of a main magnet.

The winding pattern of the tape may be the same or different across the plurality of magnet coils. For example, the winding patterns of the tapes of the plurality of magnet coils may differ in terms of the number of tapes, a number of crossings between tapes and/or the number of turns.

A plurality of magnet coils may increase the overall magnetic field strength generated by the magnet arrangement. In stacking multiple magnet coils along the major axis of the toroidal structure, a larger region with a uniform magnetic field and/or a more uniform magnetic field can be provided.

A spacing between adjacent magnet coils in the stack can be uniform or varied. For example, two or more magnet coils of the plurality of magnet coils may be equally spaced. However, a spacing between a first pair of adjacent magnet coils may also differ from a spacing between second pair of adjacent magnet coils. The magnet arrangement may comprise spacers arranged between adjacent magnet coils to maintain a desired separation distance. These spacers can be configured to be made of non-magnetic materials to avoid interfering with the magnetic field.

The plurality of magnet coils can be mechanically coupled to each other, but also to a magnet support structure. The magnet support structure can be configured to maintain the alignment of the magnet coils along the major axis and provide overall structural integrity to the magnet arrangement. In one example, the magnet support structure can be configured to maintain a predefined spatial arrangement of at least two magnet coils.

The magnet arrangement may comprise a magnet support structure configured to provide mechanical support to the one or more superconducting magnet coils. The magnet support structure can be configured to maintain a precise arrangement and/or alignment of the magnet coils. The magnet support structure can be made from materials that are both structurally robust and compatible with the cryogenic environment required for superconducting operation. For example, the magnet support structure may comprise or consist of a material of a former according to an embodiment described above.

The magnet arrangement formed by the one or more magnet coils may exhibit a circular, an oval, an O-shaped, or a D-shaped cross-section. A D-shaped cross-section can be advantageous in certain applications, such as in fusion reactor designs, where it can provide improved plasma confinement. The D-shaped cross-section can be achieved by appropriate shaping of the former and precise winding of the superconducting tape.

The stacking of multiple magnet coils along the major axis of the toroidal structure can offer several advantages. For example, a stack of magnet coils may allow for the creation of longer magnet arrangements (or magnet arrangements with extended dimensions), which can be beneficial in applications requiring extended uniform magnetic fields such as whole-body magnetic resonance devices. Furthermore, the stacked magnet coils can enable fine-tuning of a homogeneity and/or a field vector of the generated magnetic field by adjusting the current in individual magnet coils. Moreover, the inventive magnet arrangement may allow for modular construction and/or simplified maintenance (e. g. by allowing parts of the magnet arrangement to be replaced), potentially reducing manufacturing and/or servicing costs.

In a further embodiment, the inventive magnet arrangement comprises at least two tapes or at least two turns of the tape wound in a toroidal structure. The at least two tapes or the at least two turns of the tape are separated by a gap. A cooling connection, a support element and/or an electrical connection of the at least two tapes or the tape are routed through the gap between the at least two tapes or the at least two turns of the tape.

A gap may represent a space or opening between two adjacent tapes or two adjacent turns of the tape in the toroidal structure. The gap may provide a separation between the at least two tapes or the two turns of the tape and provide access for routing electrical connections. A width of the gap can be selected based on factors such as the dimensions of the electrical connections, cooling requirements, and structural considerations.

Electrical connections may comprise conductive pathways or conductive elements that enable electrical current to flow to and from the tapes. The electrical connections can comprise leads, wires, or other conductive elements suitable for carrying the required currents. The electrical connections can comprise or consist of metals such as copper, silver, gold, or other highly conductive metals. In some embodiments, the electrical connections may comprise a superconducting material according to an example described above. The electrical connection may be configured to electrically connect a tape to a power supply and/or another tape.

The term routing may refer to the process of directing or guiding the electrical connections through a designated path. The electrical connections can be fed or passed through the gap between the at least two tapes or the two turns of the tape. The electrical connection may also be routed through a section of a former or a channel provided within the former.

In one embodiment, the electrical connection is routed through the gap from a surface of the toroidal structure facing the minor axis to a surface of the toroidal structure facing away from the minor axis or vice versa.

In routing electrical connections through the gap between the at least two tapes or the at least two turns of the tape, an electrical contact with the at least two tapes or the tape may be provided while maintaining the overall toroidal structure of the tape or the at least two tapes and the associated advantages.

An electrical connection routed through a gap between individual tapes or turns of the tape may favourably allow for a more compact design of the magnet coil, for example by utilizing spaces provided by the winding pattern. By utilizing the spaces between individual tapes or turns of the tape for electrical connections, an overall size of the magnet arrangement can be minimized. This can be advantageous in applications where space is limited, such as in magnetic resonance devices. This approach can also facilitate assembly and/or maintenance of the magnet arrangement, as the electrical connections can be accessed without disturbing the winding pattern of the tapes.

According to an embodiment, the magnet arrangement comprises a first tape and a second tape wound into a toroidal structure. The first tape and the second tape can be configured as superconducting tapes. The first tape and the second tape can be wound in a helical pattern around a minor axis of the toroidal structure. The first tape and the second tape may be wound in such a way to maintain a substantially constant angle, for example a zero-degrees angle, between a main surface of each tape and a direction of a magnetic field generated by the magnet coil or magnet arrangement throughout the toroidal structure.

The gap between the first tape and the second tape can be configured to provide a space for routing an electrical connection. The electrical connection can be configured to supply current to the first tape and/or the second tape. The electrical connection can also be configured to electrically connect the first tape and the second tape.

The gap may allow for thermal expansion and contraction of the at least two tapes or the at least two turns of the tape during cooling and warming cycles of the magnet arrangement, but also during ramping of the magnetic field. Thus, the gap may favourably prevent mechanical stress on the tapes that could potentially damage the superconducting material.

Moreover, the gap between the at least two tapes or the at least two turns of the tape may allow for an insertion of a spacer and/or insulating material. A spacer and/or insulating material can be configured to maintain proper separation between the tapes and/or prevent electrical shorts. The spacer may also be configured to provide additional mechanical support to the at least two tapes or the at least two turns of the tape.

The electrical connection routed through the gap can be configured to connect the at least two tapes in series or in parallel. A series connection can allow for a unique current flowing through the magnet coil (which can be a requirement for magnets used in magnetic resonance or nuclear magnetic resonance applications), but also enable a higher total voltage across the magnet arrangement. A parallel connection can allow for a higher total current capacity. The specific connection scheme can be selected based on the requirements of the application in which the inventive magnet arrangement is used.

According to an embodiment, the gap between the at least two tapes or the at least two turns of the tape can be configured to facilitate cooling of the magnet arrangement. For example, cooling connections can be routed through the gap, allowing for the circulation of a cooling fluid and/or the connection of a solid thermal conductor. Routing cooling connections or solid thermal conductors through the gap between the at least two tapes or the at least two turns of the tape may favourably allow for a more efficient or direct heat removal from, helping to maintain the superconducting state of the tape or the at least two tapes.

A configuration of one or more tapes wound into a toroidal structure with gaps provided between the tapes or turns of the tape may allow for an improved efficiency, compact design, and/or enhanced maintainability of the inventive magnet arrangement. The magnet arrangement may favourably allow for a better utilization of superconducting materials while facilitating electrical and/or thermal management functions.

According to a further embodiment of the inventive magnet arrangement, the tape is wound in such a way that a middle section of the tape is arranged at a surface of the toroidal structure facing towards the major axis of the toroidal structure, and distal ends of the tape are arranged on a surface of the toroidal structure facing away from the major axis of the toroidal structure.

A middle section of the tape may represent a portion of the tape located approximately halfway between the two ends of the tape. However, the middle section may also be located closer to a first distal end of the tape than to a second distal end of the tape. The middle section may comprise or account for less than 20 %, 15 %, 10 % or 5 % of the total length of the tape.

Distal ends of the tape may represent portions of the tape located at or near opposing ends of the tape. The distal ends can each comprise or account for less than 10 % or less than 5 % of the total length of the tape.

A surface of the toroidal structure facing towards the major axis may represent an inner surface of the toroidal structure that is closest to and/or oriented towards the major axis of the toroidal structure. The surface of the toroidal structure facing towards the major axis can be convex in shape.

A surface of the toroidal structure facing away from the major axis may represent an outer surface of the toroidal structure that is furthest from and/or oriented away from the major axis of the toroidal structure. The surface of the toroidal structure facing away from the major axis can be convex in shape.

According to an embodiment, the tape can be wound such that the middle section of the tape is arranged at the surface of the toroidal structure facing towards the major axis of the toroidal structure, whereas a lead entry and a lead exit of the tape (e. g. corresponding to the distal ends of the tape) are toroidally wound in opposite directions to both finish on a surface of the toroidal structure facing away from the major axis, particularly in an opposite direction. The distal ends may be arranged at an outer surface of the magnet coil similar to conventionally wound double pancake coils. The lead entry and lead exit can be arranged at any point on the surface of a former according to a previously described embodiment. The precise placement of the lead entry and lead exit can be determined by the requirement to be able to connect multiple coils together efficiently.

In arranging a middle section of the tape at a surface of the toroidal structure facing towards the major axis of the toroidal structure, and distal ends of the tape at a surface of the toroidal structure facing away from the major axis of the toroidal structure, electrical connections can be provided similar to conventionally wound double pancake coils, while maintaining the advantages provided by the tape wound into the toroidal structure according to an embodiment described above.

In a second aspect, the invention concerns a method of manufacturing a magnet arrangement. The method comprises forming a magnet coil by winding a tape comprising a superconducting material into a toroidal structure. The tape is wound in such a way that a surface normal vector of a main surface of the tape rotates around a minor axis of the toroidal structure during a process of winding.

The inventive method may involve forming a magnet coil by winding a tape comprising a superconducting material into a toroidal structure. The magnet coil may represent or form a part of an inventive magnet arrangement according to an embodiment described above.

According to an embodiment of the inventive method, the tape is wound in such a way that an angle between a direction of a magnetic field generated by the magnet coil, or optionally a magnet arrangement comprising the magnet coil, and a main surface of the tape is substantially constant throughout the toroidal structure when the magnet coil is in an operating state. The tape may be wound in such a way that a local direction of the magnetic field generated by the magnet coil or the magnet arrangement comprising the magnet coil is oriented substantially in parallel to the main surface of the tape throughout the toroidal structure when the magnet coil is in an operating state.

The rotation of the surface normal vector of the tape during winding may allow maintaining a substantially constant angle between a direction of a magnetic field generated by the magnet coil or magnet arrangement and the main surface of the tape throughout the toroidal structure.

The tape may be wound in such a way that a surface normal vector of a main surface of the tape rotates around a centreline of the tape during a process of winding. The centreline may represent a longitudinal axis of the tape. For example, the centreline can run along a geometric centre of the tape. The centreline may also represent a path along which the tape is wound to form the toroidal structure.

The inventive winding technique may enable an efficient use of the superconducting material of the tape, as the performance of superconducting materials can be sensitive to the angle of the applied magnetic field.

The tape may be configured according to an embodiment described above. The inventive method of manufacturing a magnet arrangement may allow manufacturing of a magnet arrangement according to an embodiment described above. For example, a magnet arrangement manufactured via the method according to the second aspect of the invention may correspond to a magnet arrangement according to the first aspect of the invention.

The process of winding the tape may involve wrapping or coiling the tape around a central axis, such as the minor axis of the toroidal structure. In the context of the inventive method, the process of winding the tape may comprise forming the tape into a toroidal structure. A toroidal structure may represent a three-dimensional geometric shape according to an embodiment described above.

A surface normal vector may represent a vector that is perpendicular to the main surface of the tape at a given point. The main surface of the tape may represent the largest or primary surface of the tape.

The inventive method can involve winding the tape onto a former and/or a magnet support structure. The former and/or magnet support structure can be configured according to an embodiment described above.

The method can involve winding the tape using a "no-insulation" technique, where adjacent turns of the tape are in direct contact with each other. This approach may increase the overall current density of the magnet coil and/or help to prevent "hot spots" and reduce the risk of damage to the tape if the magnet coil should quench.

The inventive method may favourably allow for an efficient use of superconducting material. By winding the tape into a toroidal structure in such a way that the surface normal vector of the main surface of the tape rotates around the minor axis of the toroidal structure, a substantially constant angle between the direction of the magnetic field generated by the magnet coil or magnet arrangement and the main surface of the tape can be maintained throughout the toroidal structure. This can potentially reduce the amount of superconducting material required for a given magnetic field strength, allowing for more cost-effective and/or compact magnet systems.

In a further embodiment of the inventive method, the tape is helically wound around the minor axis of the toroidal structure.

The process of helically winding the tape may comprise winding the tape in a pattern where the tape follows a spiral path around the minor axis of the toroidal structure. This winding technique may enable the tape to be arranged in a way that maintains a substantially constant angle between the direction of the magnetic field generated by the magnet coil or magnet arrangement and the main surface of the tape throughout the toroidal structure. Particularly, this winding technique may enable the tape to be arranged in a way that maintains a substantially constant zero-degree angle between the direction of the magnetic field generated by the magnet coil or magnet arrangement and the main surface of the tape throughout the toroidal structure.

The process of helically winding the tape may result in a helical winding pattern which can be characterized by parameters such as winding angle (or pitch), number of turns, and winding direction. These parameters can be adjusted to optimize the performance of the magnet coil and achieve the desired magnetic field characteristics. The helical winding can be performed using specialized winding equipment, for example a winding apparatus according to an embodiment described above, configured to precisely control a tape tension, winding angle, and spacing between adjacent turns. The winding apparatus may also be configured to precisely control the orientation or axial tilt of the tape as it is wound around the minor axis.

In some examples, the helical winding can be performed in multiple layers, with each layer wound in the same or opposite direction as the previous layer. This multi-layer helical winding can enable higher current capacity and improved magnetic field uniformity. Furthermore, using as much of the surface of a former according to a previously described embodiment may favourably improve mechanical and thermal stability of the magnet coil.

During the helical winding, the tape can be continuously rotated around its centreline as it is wound around the minor axis of the toroidal structure, which can result in the surface normal vector of the main surface of the tape completing one or more full rotations around the minor axis for each turn around the major axis of the toroidal structure. The number of rotations of the surface normal vector per turn around the major axis of the toroidal structure (as defined, e. g., by the winding angle) can be adjusted based on the desired magnetic field characteristics and/or the properties of the superconducting material.

The helical winding technique according to the invention can be applied to a single continuous tape or to multiple separate tapes. For example, each turn or each tape can be wound in a helical pattern. The winding patterns of each turn or each tape may be similar, or in some examples offset or interleaved, to achieve the desired overall structure and magnetic field properties.

The minor axis around which the tape is helically wound can be defined by the shape of a former or support structure. The former can provide a surface or guide for the tape to be wound against, helping to maintain the desired toroidal shape and helical pattern of the tape. The former may comprise receiving surfaces, grooves, channels, or other features configured to guide and/or support the tape during the winding process. For example, the former may comprise receiving surfaces or grooves arranged in different radial planes or radial sections allowing the tape or multiple tapes to be wound over each other in multiple layers.

The helical winding of the tape around the minor axis of the toroidal structure may favourably enable the production of a magnet arrangement with improved magnetic field uniformity and efficiency. By maintaining a substantially constant angle (e. g. a zero-degree angle) between the direction of the magnetic field and the main surface of the tape throughout the toroidal structure, the current-carrying capacity of the superconducting material can be improved or optimized, potentially reducing the amount of superconducting material required to achieve a desired magnetic field strength.

In a third aspect, the invention concerns a magnetic resonance device. The magnetic resonance device comprises a magnet arrangement according to any one of the embodiments described above. The magnetic resonance device is configured to acquire magnetic resonance data from an object positioned in an imaging region of the magnetic resonance device.

A magnetic resonance device can be configured to acquire magnetic resonance data, for example diagnostic magnetic resonance image data, from an object positioned in an imaging region of the magnetic resonance device. The object can be an inanimate object or a patient, particularly a human or an animal.

The magnetic resonance device may represent a closed bore scanner. A closed bore scanner can comprise a substantially cylindrical bore circumferentially enclosing the imaging region. The closed bore scanner may comprise a main magnet including one or more magnet coils circumferentially encompassing the imaging region along an axial direction or an axis of rotational symmetry of the cylindrical bore. The one or more magnet coils may be configured according to an embodiment described above. A main direction of a magnetic field provided by the one or more magnet coils can be oriented substantially in parallel to a direction of access of the object to the imaging region and/or the axial direction of the cylindrical bore. The main magnet may comprise a plurality of magnet coils stacked concentrically along the axial direction of the cylindrical bore. The axial direction of the cylindrical bore may coincide with the major axis of the magnet coils. The main magnet may form a part of an inventive magnet arrangement according to an embodiment described above.

In other examples, the magnetic resonance device can be configured as an open bore scanner, a C-type scanner, a single-sided scanner, or the like. For example, the magnet coils according to an embodiment described above may be incorporated into one or more poles or pole faces of the open bore scanner.

The magnetic resonance device can comprise further components required for proper operation of the magnetic resonance device. For example, the magnetic resonance device can comprise a cryostat, an outer vacuum chamber, a magnet support structure, and/or one or more thermal radiation shields. In certain embodiments, the magnetic resonance device may comprise one or more cryogen vessels or one or more thermal buffers.

The magnetic resonance device may represent a "dry" system comprising a minimum of cryogen or no cryogen at all. For example, the magnetic resonance device can comprise one or more small cryogen vessels thermally connected to the magnet arrangement via a thermal bus, particularly a solid thermal conductor. The one or more small cryogen vessels can contain a volume of less than 10 l, less than 5 l, or less than 1 l of cryogen. According to an embodiment of the magnetic resonance device, a cryogen vessel is omitted, and the magnet arrangement is cooled entirely via thermal conduction. A "dry" system may also be characterized by the fact that the one or more magnet coils are not directly immersed in a cryogen. For example, the magnet arrangement of a "dry" system may be thermally and mechanically connected to a cryocooler by means of a solid thermal conductor.

In one embodiment, at least two magnet coils of the magnet arrangement are mechanically coupled or mechanically connected to each other. The at least two magnet coils can be mechanically connected in such a way to form a cohesive or coherent structure. For example, formers carrying the at least two magnet coils can be mechanically connected via spacers or support elements routed through gaps in the winding pattern of the tapes of the at least two magnet coils.

According to an embodiment, each magnet coil of the one or more magnet coils comprises a former according to an embodiment described above. It is conceivable that a first former of a first magnet coil is mechanically connected to a second former of a second magnet coil via one or more support elements. The one or more support elements may be configured to pass through gaps provided between turns of the tape or between separate tapes of the first magnet coil and the second magnet coil.

The magnet arrangement may comprise a magnet support structure configured to provide mechanical support to the one or more magnet coils. The magnet support structure can be configured to maintain a predefined spatial arrangement of at least two magnet coils. In an example, the magnet support structure is configured to be mechanically connected to a cryostat structure or support structure, such as an outer vacuum chamber, of the magnetic resonance device. The magnet support structure may be mechanically connected to formers of the one or more magnet coils via one or more support elements according to an embodiment described above.

The magnet arrangement may be configured to provide a magnetic field suitable for use in a magnetic resonance imaging examination. The magnet arrangement can be configured to provide a static or main magnetic field (i. e. a B0-field) within the imaging region of the magnetic resonance device. For example, the magnet arrangement can be configured to generate a main magnetic field having a maximum magnetic field strength between 0.1 and 9 Tesla, for example about 0.5 Tesla, 1.5 Tesla, 3 Tesla, or 7 Tesla.

A magnet coil may comprise at least two tapes or at least two turns of a tape wound into a toroidal structure. The at least two tapes or at least two turns of the tape may be separated by a gap. An Electrical connection can be routed through the gap between the at least two tapes or the at least two turns of the tape according to an embodiment described above. It is also conceivable that a cooling connection and/or a support element are routed through the gap between the at least two tapes or the at least two turns of the tape.

The tape can be wound in such a way that a middle section of the tape is arranged at a surface of the toroidal structure facing towards the major axis, and distal ends of the tape are arranged at a surface of the toroidal structure facing away from the major axis. Thus, when stacking two magnet coils along the axial direction (e. g. the major axis of the toroidal structure), the middle sections of the two magnet coils can be electrically connected via a connecting element. Furthermore, one distal end of a first magnet coil may be electrically connected to one distal end of a second magnet coil via a connecting element to form a double toroid coil. The unconnected distal end of the first magnet coil and the unconnected distal end of the second magnet coil of the double toroid coil may act as an input lead and an output lead. The input lead and the output lead may be arranged on a surface of the toroidal structure facing away from the major axis.

The inventive magnetic resonance device shares the advantages of the inventive magnet arrangement according to an embodiment described above.

According to an embodiment, the inventive magnetic resonance device comprises a cooling system. The cooling system can be configured to cool the former of a magnet arrangement according to an embodiment described above.

The cooling system may comprise a cryocooler according to an embodiment described above. The cooling system can be configured to maintain the tape at a temperature below the critical temperature of the superconducting material.

According to an embodiment, the cooling system comprises a cryogen vessel. A cryogen vessel can be configured to store or preserve a fluid, for example a cryogen, at a desired temperature level. The fluid or cryogen can exhibit a low boiling point. Examples of suitable fluids or cryogens are argon, nitrogen, neon, helium, or the like. The desired temperature level can substantially correspond to a superconducting temperature of the superconducting material of the tape.

According to an embodiment, one or more magnet coils of the magnet arrangement each comprise a former including a cooling circuit and/or a precooling circuit according to an embodiment described above. For example, the cooling circuit and/or the precooling circuit may be embodied as one or more cooling channels in the former.

The cooling system can be configured to circulate a cooling fluid through a section of the former. For example, the cooling system can be configured to circulate a cooling fluid or coolant through cooling channels in the former. The cooling fluid or coolant can be a cryogen, such as liquid helium, liquid neon, liquid argon, liquid nitrogen, or any other suitable cryogenic fluid. The cooling system can comprise a pump configured to circulate the cooling fluid through the cooling channels. However, the cooling system may also be driven by evaporation of the coolant or cryogen in the cooling channels of the former. The cooling system can comprise a cryocooler, a compressor, but also associated piping or cooling channels to circulate the cooling fluid.

Additionally or alternatively, one or more magnet coils can be cooled using thermal conduction. For example, the magnetic resonance device may comprise a solid thermal conductor connected to a cryocooler of the magnetic resonance device. The solid thermal conductor may be thermally and mechanically connected to a former of the one or more magnet coils. This approach can simplify the cooling system design and/or reduce the amount of costly cryogen, but also a risk of cryogen leaks.

The former can be configured to accommodate the cooling fluid. For example, the former can comprise one or more cooling channels through which the cooling fluid can be circulated. These cooling channels can be integrated within the structure of the former, enabling an efficient heat transfer from the superconducting tape to the cooling fluid.

The cooling system can comprise temperature sensors and control mechanisms to regulate the temperature of the former and/or the superconducting tape. The magnetic resonance device may comprise a control unit configured to monitor and adjust the cooling system based on temperature readings and operational requirements.

The cooling system may favourably enable stable and reliable operation of the magnet arrangement in the magnetic resonance device.

In a further embodiment of the inventive magnetic resonance device, the magnet arrangement is configured to generate a magnetic field strength suitable for magnetic resonance imaging applications.

A magnetic field strength suitable for magnetic resonance imaging applications may be characterized as a magnetic field strength that enables the acquisition of diagnostic-quality magnetic resonance images. The magnetic field strength can be in a range that provides sufficient signal-to-noise ratio and spatial resolution for visualizing anatomical structures and pathologies of interest.

For example, the magnet arrangement may be configured to provide a magnetic field having a magnetic field strength between 0.1 Tesla and 7 Tesla. In some examples, the magnetic field strength can be approximately 0.5 Tesla, 1.5 Tesla, 3 Tesla, or 7 Tesla. However, the magnetic field strength of the magnetic field may be lower or higher and can be selected based on factors such as the desired image quality, scan time, and specific clinical application.

A magnet coil according to the invention can be configured to generate a desired magnetic field strength by utilizing an appropriate number of turns of superconducting tape and/or an appropriate number of superconducting tapes, applying a suitable current, and employing a coil geometry optimized for field homogeneity. The toroidal structure of the magnet coil can enable efficient generation of magnetic fields while maintaining field uniformity in the imaging region.

The inventive magnetic resonance device may favourably allow for an improved efficiency in the use of superconducting materials. The constant angle between the direction of the magnetic field and the main surface of the tape throughout the toroidal structure can allow for improved performance of the superconducting material in comparison to prior art solutions.

Embodiments of the invention are illustrated in the drawings and will be described in more detail below. The same reference numerals are used for the same features in different figures. The figures show:
- Fig. 1: shows a schematic representation of an embodiment of an inventive magnetic resonance device.
- Fig. 2: shows a perspective view of a toroidal structure.
- Fig. 3: shows a perspective view of an embodiment of an inventive magnet arrangement.
- Fig. 4: shows a perspective view of an embodiment of an inventive magnet arrangement.
- Fig. 5: shows a cross-sectional view of an embodiment of an inventive magnet arrangement.
- Fig. 6: shows a cross-sectional view of an embodiment of an inventive magnet arrangement.
- Fig. 7: shows a cross-sectional view of an embodiment of an inventive magnet arrangement.
- Fig. 8: shows a cross-sectional view of an embodiment of an inventive magnet arrangement.
- Fig. 9: shows a perspective view of an embodiment of an inventive magnet arrangement.
- Fig. 10: shows a perspective view of an embodiment of an inventive magnet arrangement.
- Fig. 11: shows a perspective view of an embodiment of an inventive magnet arrangement.
- Fig. 12: shows schematic representation of a conventional magnet coil.

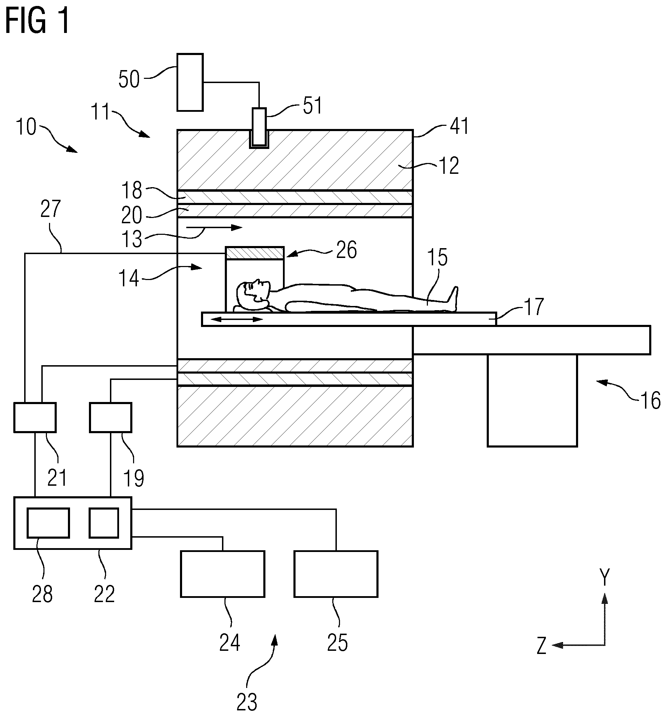

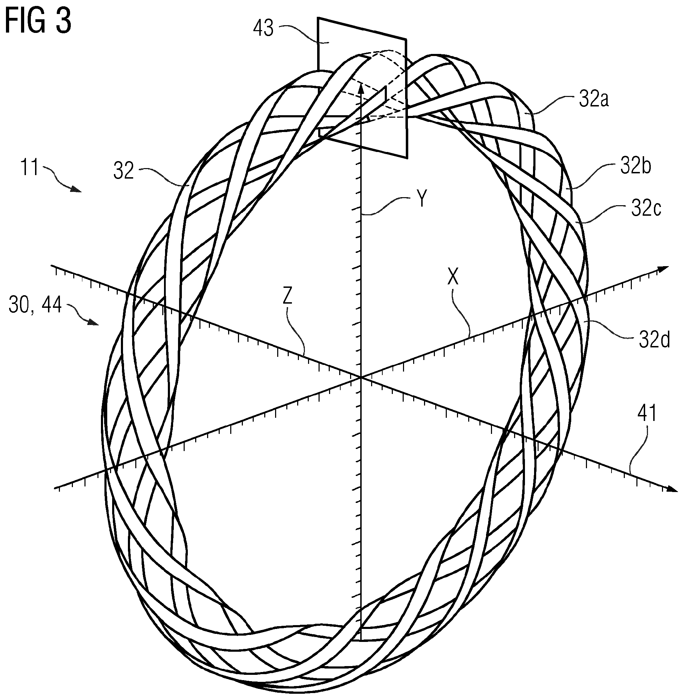

Fig. 1 shows an embodiment of a magnetic resonance device 10 according to the invention. The magnetic resonance device 10 comprises a static field magnet or main magnet 12 including one or more magnet coils 30 (see Fig. 3) configured to provide a homogenous, static magnetic field 13 (B0 field). The static magnetic field 13 permeates an imaging region 14 configured to receive an imaging object, such as a patient 15. The imaging region 14 may correspond to an inner volume of a patient bore configured to accommodate a patient 15 during a magnetic resonance measurement. In the depicted embodiment, the imaging region 14 is encompassed by the main magnet 12 in a circumferential direction. The main magnet 12 forms a part of an inventive magnet arrangement 11. The main magnet 12 may comprise one or more magnet coils 30 (see Figs. 3 to 11) stacked along a axial direction of the patient bore of the magnetic resonance device 10.

The magnetic resonance device 10 may comprise a patient positioning device 16 configured to transport the patient 15 into the imaging region 14. For example, the patient positioning device 16 may comprise a patient table 17 configured to transport a diagnostically relevant body region of the patient 15 into an imaging volume or isocentre (not shown) of the magnetic resonance device 10. The magnet arrangement 11 and other components of the magnetic resonance device 10 may be concealed in a housing (not shown).

The magnetic resonance device 10 may comprise a gradient system including one or more gradient coils 18. The one or more gradient coils 18 may be configured to generate gradient magnetic fields in different, preferably orthogonally oriented, spatial directions. The gradient magnetic fields can be used for spatial encoding of magnetic resonance signals or magnetic resonance data acquired during a magnetic resonance measurement. The one or more gradient coils 18 can be activated or controlled via an appropriate control signal provided by a gradient control unit 19.

The magnetic resonance device 10 may further comprise an integrated radiofrequency antenna 20 (e. g. a body coil). The radiofrequency antenna 20 may be activated or controlled via a radiofrequency control unit 21. The radiofrequency control unit 21 may be configured to control the radiofrequency antenna 20 to generate a high frequency magnetic field and emit radiofrequency excitation pulses into the imaging region 14. The gradient coils 18 and the radiofrequency antenna 20 may be connected a respective gradient control unit 19 and a radiofrequency control unit 21 via signal connections 27.

The magnetic resonance device 10 may further comprise a local coil 26. The local coil 26 may be positioned on or in proximity to a diagnostically relevant body region of the patient 15. The local coil 26 may be configured to emit radiofrequency excitation pulses into the patient 15 and/or receive magnetic resonance signals from the patient 15. It is conceivable, that the local coil 26 is controlled via the radiofrequency control unit 21.

Preferably, the magnetic resonance device 10 comprises a control unit 22 configured to control the magnetic resonance device 10. The control unit 22 may comprise a processing unit 28 configured to process acquired magnetic resonance signals and reconstruct magnetic resonance images from the acquired magnetic resonance signals. The processing unit 28 may also be configured to process input from a user of the magnetic resonance device 10 and/or provide an output to the user. For this purpose, the processing unit 28 and/or the control unit 22 can be connected to a display unit 24 and an input unit 25 via a suitable signal connection. For a preparation of a magnetic resonance measurement, preparatory information, such as imaging parameters or patient information, can be provided to the user via the display unit 24. The input unit 25 may be configured to receive information and/or imaging parameters from the user. The display unit 24 and the input unit 25 may form a part of a user interface 23 configured to enable the user to interact with the magnetic resonance device 10.

In the example depicted in Fig. 1, the magnetic resonance device 10 comprises a cryocooler 50 configured to cool the main magnet 12, but also other components of the magnet arrangement 11 and/or the magnetic resonance device 10. The cryocooler 50 may comprise a compressor (not shown) supplying pressurized gas or cryogen to the cryocooler 50.

The cryocooler 50 may include a cold head 51 comprising one or more cooling stages (not shown). According to an embodiment, a second stage of the cold head 51 is thermally connected to the main magnet 12, while a first stage of the cold head 51 is thermally connected to other components of the magnet arrangement 11, such as a thermal radiation shield, a further thermal radiation shield, a shield tube, a buffer unit, or the like (not shown).

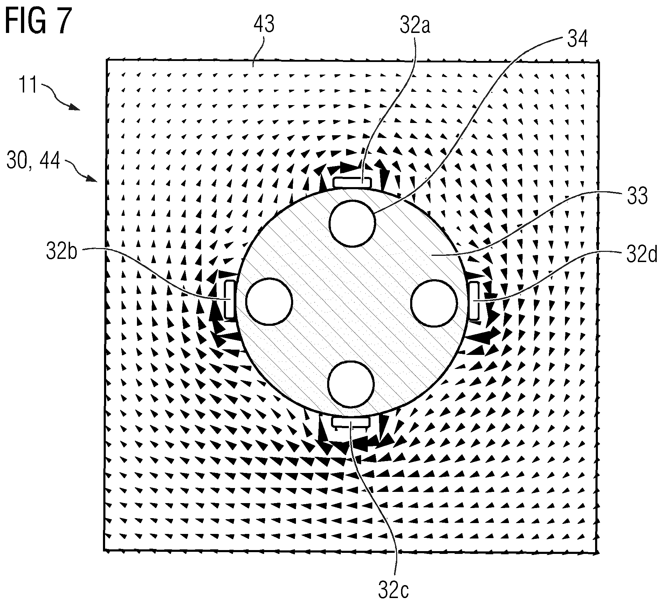

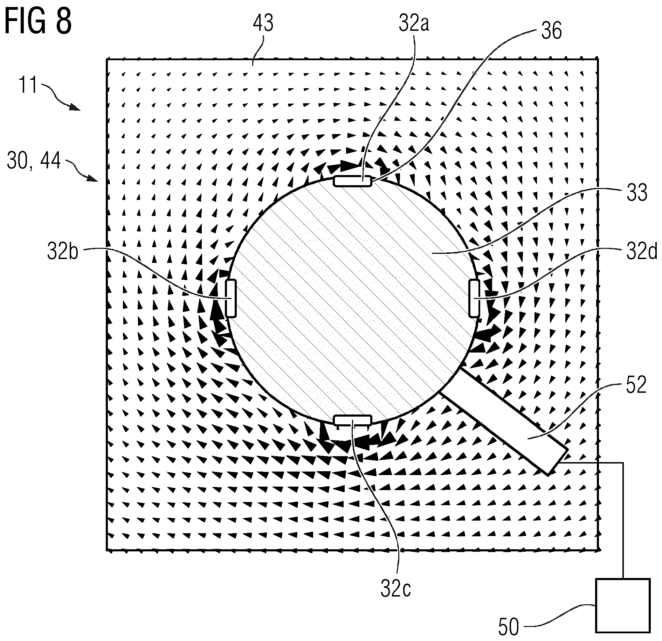

According to an embodiment, the cold head 51 is thermally and mechanically connected to a former 33 of a magnet coil 30 via a solid thermal conductor (see Fig. 8). However, it is also conceivable that a cooling fluid which is cooled, for example by the cold head 51 or an external source, is circulated through cooling channels 34 incorporated into the former 33 of the magnet coil 30 (see Fig. 7).

Of course, the magnetic resonance device 10 may comprise further components and/or functions which are common in magnetic resonance devices. The general operation of a magnetic resonance device is known to those skilled in the art, so a more detailed description is omitted.

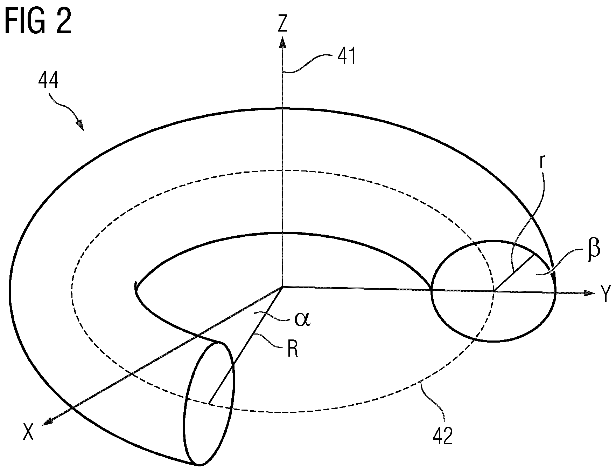

Fig. 2 shows a schematic representation of a toroidal structure 44. The toroidal structure 44 may comprise a major axis 41 and a minor axis 42. The major axis 41 may represent a central axis of rotational symmetry for the toroidal structure 44, while the minor axis 42 can represent a circular or oval cross-section of the toroidal structure 44.

The toroidal structure 44 comprises a ring-like shape, resembling a donut or a closed tube. The toroidal structure 44 can be characterized by its circular or oval cross-section that revolves around the major axis 41 to represent the toroidal structure 44, creating a continuous surface of the toroidal structure 44.

The magnet coil 30 (see Fig. 3) of the magnet arrangement 11 according to the invention may comprise a shape similar to the toroidal structure 44 depicted in Fig. 2. For example, one or more tapes 32 comprising a superconducting material can be wound around the minor axis 42 to form a ring torus. The wound tape 32 may comprise the shape of a toroidal structure 44.

The magnet arrangement 11 can comprise one or more tapes 32 comprising a high-temperature superconducting material twisted into helix shapes and wound around the minor axis 42, but also the major axis 41, to form the toroidal structure 44 (see Fig. 3). This winding configuration may allow for an angle between a local direction of the magnetic field generated by the magnet coil 30 or magnet arrangement 11 and the main surface of the tape 32 to be substantially constant throughout the toroidal structure 44. For example, the winding configuration may allow for the main surface of the tape to be oriented substantially in parallel to the local direction of the magnetic field generated by the magnet coil 30 or magnet arrangement 11 throughout the toroidal structure 44

The magnet arrangement 11 can comprise a plurality of magnet coils 30 stacked along the major axis 41 of the toroidal structure 44. This configuration can enable the creation of a magnetic field strength suitable for magnetic resonance imaging applications.

Fig. 3 shows a schematic representation of an embodiment of a magnet arrangement 11 according to the invention. The magnet arrangement 11 comprises a magnet coil 30 including a tape 32 comprising a superconducting material. The tape 32 is wound into a toroidal structure 44. In the depicted embodiment, the tape 32 is helically wound around the minor axis 42 of the toroidal structure 44 (see Fig. 2).

The magnet arrangement 11 can comprise a tape 32a and a further tape 32b wound into a toroidal structure 44 in accordance with a previously described embodiment. In the example illustrated in Fig. 3, the magnet arrangement 11 comprises four tapes 32a, 32b, 32c, and 32d wound into a toroidal structure 44. In certain embodiments, the elements 32a, 32b, 32c, and/or 32d can represent different turns of the tape 32.

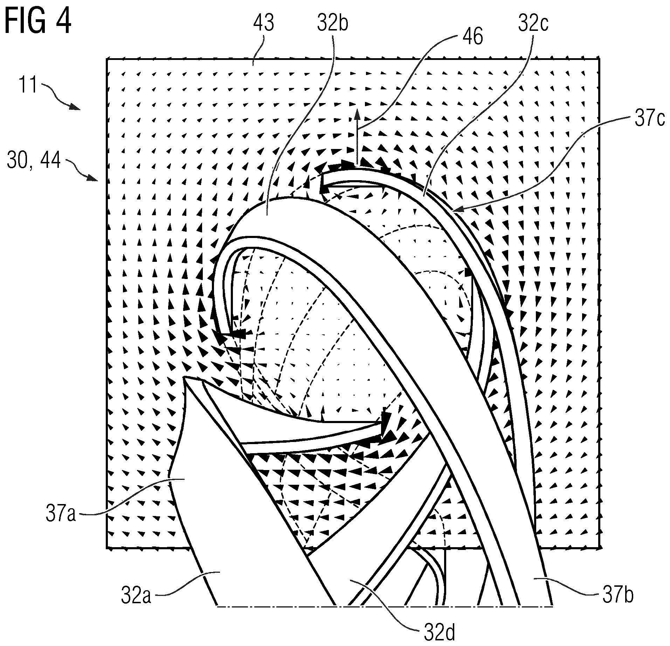

The toroidal structure 44 is formed around the major axis 41. The major axis 41 can also represent an axis of rotational symmetry. In Fig. 3, a cutting plane 43 is shown intersecting a section of the magnet coil 30 in a radial plane, providing a cross-sectional view along the minor axis 42 of the magnet arrangement 11 (see Figs. 4 to 8).

According to an embodiment (not shown), one or more tapes 32 are wound in such a way that middle sections of the one or more tapes 32 are arranged at a surface of the toroidal structure 44 facing towards the major axis 41 of the toroidal structure 44. Distal ends of the one or more tapes 32 can be arranged on a surface of the toroidal structure 44 facing away from the major axis 41 of the toroidal structure 44.

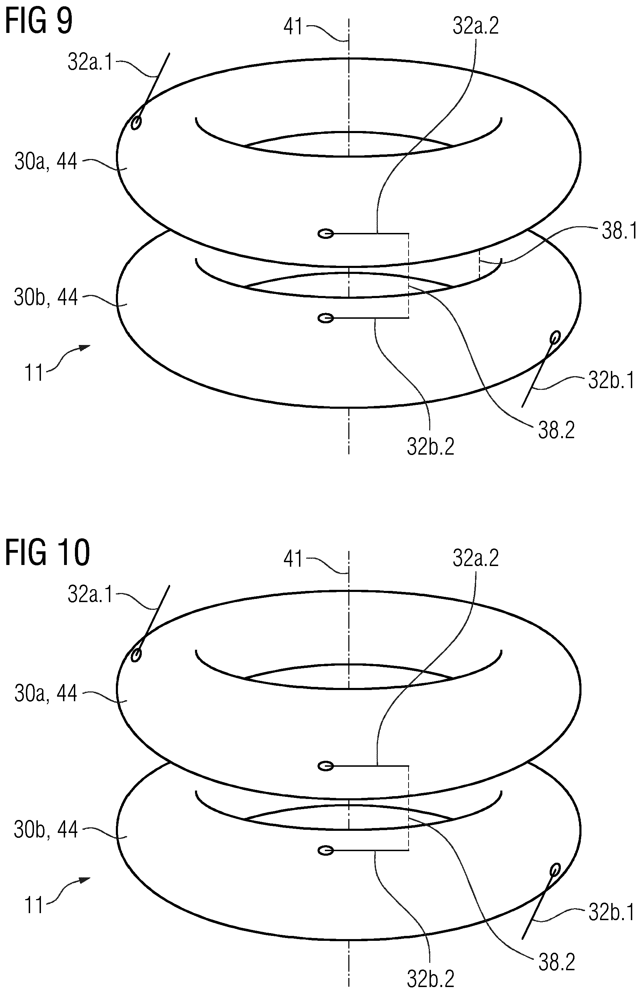

The magnet arrangement 11 can comprise a plurality of magnet coils 30 stacked along the major axis 41 of the toroidal structure 44 (see Fig. 9). In stacking a plurality of magnet coils 30 along the major axis 41 of the toroidal structure 44, a stronger magnetic field and/or a more uniform magnetic field distribution within the imaging region 14 of the magnetic resonance device 10 may be achieved.

Fig. 4 shows a schematic representation of an embodiment of a magnet arrangement 11 according to the invention. The magnet arrangement 11 comprises a magnet coil 30 including a tape 32 comprising a superconducting material. The tape 32 is wound into a toroidal structure 44. In the depicted embodiment, the magnet coil 30 comprises multiple tapes 32a, 32b, 32c, and 32d wound into a toroidal structure 44. In other embodiments (not shown), the magnet coil 30 may comprise multiple turns of a single tape 32 wound into a toroidal structure 44.

Fig. 4 illustrates a perspective view on a radial section 43 of the magnet coil 30. The radial section 43 depicted in Fig. 4 may coincide with the cutting plane 43 of the embodiment depicted in Fig. 3.

The tapes 32a, 32b, 32c and 32d (32a-d) can comprise a high-temperature superconducting material, such as REBCO, YBCO, BSCCO, or MgB2. The high-temperature superconducting material may enable the magnet coil 30 to generate a magnetic field while operating at higher temperatures compared to low-temperature superconductors.

Fig. 4 illustrates how a surface normal vector 46 of the main surface 37c of the tape 32c rotates around the minor axis 42 (see Fig. 2) of the toroidal structure 44 when moving along the minor axis 42. This rotation, or rather the twisting of the tape 32, allows maintaining a substantially constant angle between the main surfaces 37 of the tapes 32 and the local direction magnetic field generated by the magnet coil 30.

The cones or arrows in the radial section 43 may represent the local directions of the magnetic field (or magnetic field vectors) around the tapes 32a-d. Fig. 4 shows that the magnetic field vectors in the cutting plane 43 are oriented substantially in parallel to the main surfaces 37 of the tapes 32. The magnetic field vectors are oriented substantially in parallel to the main surfaces 37 of the tapes 32 throughout the toroidal structure 44 (e. g. along the entire lengths of the tapes 32a-d).

In the present example, the origin of the surface normal vector 46 is in the plane of the radial section 43 and thus, the surface normal vector 46 is substantially perpendicular to the local direction of the magnetic field.

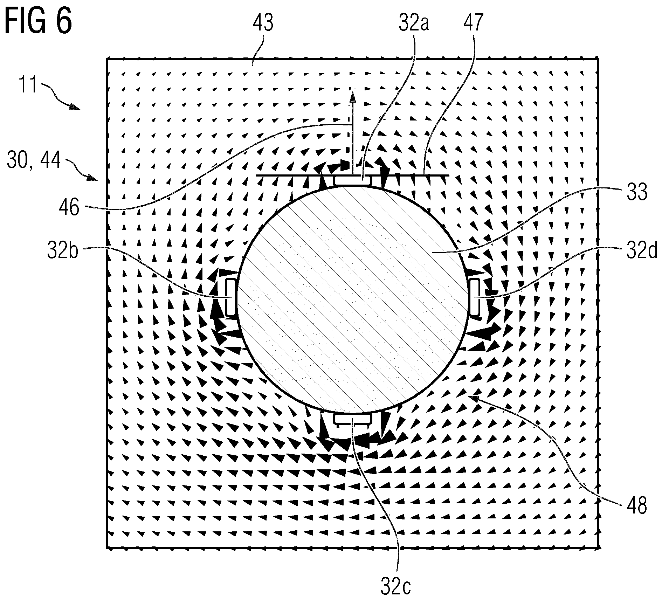

According to an embodiment, the magnet arrangement 11 comprises a former 33 (see Figs. 6 to 8) configured to provide structural support for the magnet coil 30. The former 33 can be configured to accommodate a cooling fluid to cool the magnet coil 30. Additionally or alternatively, the former 33 can be thermally and mechanically connected to a cooling system (e. g. a cold head 51 of a cryocooler 50 as shown in Fig. 1) via a solid thermal conductor.

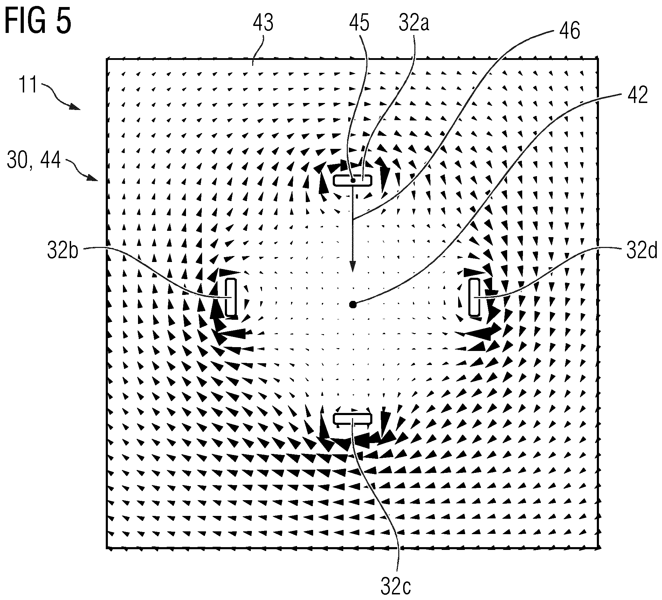

Fig. 5 shows a schematic representation of a further embodiment of a magnet arrangement 11 according to the invention. The magnet arrangement 11 comprises a magnet coil 30 including a tape 32 comprising a superconducting material. The tape 32 is wound into a toroidal structure 44.

Fig. 5 illustrates a perspective view on a radial section 43 of the magnet coil 30. The radial section 43 depicted in Fig. 5 may coincide with the cutting plane 43 of the embodiment depicted in Fig. 3.

In the depicted embodiment, the magnet coil 30 comprises multiple superconducting tapes 32a-d wound into a toroidal structure 44. The tapes 32a-d are arranged around a minor axis 42 of the toroidal structure 44. Each tape 32a-d is twisted as it follows a helical path along the minor axis 42. For example, the tape 32a is wound in such a way that the surface normal vector 46 of the tape 32a rotates around its centreline 45 when moving along the minor axis 42. Surface normal vectors of the tapes 32b, 32c, and 32d can revolve around respective centrelines of the tapes 32b, 32c, and 32d in a similar fashion. This winding configuration can allow for a consistent angle between the main surfaces of the tapes 32a-d and the local directions of the magnetic field generated by the magnet coil 30 or magnet arrangement 11.

According to an embodiment, one or more tapes 32 of the magnet coil 30 are wound in such a way that the surface normal vectors of the inner main surfaces along the centrelines of the one or more tapes 32 substantially point towards or intersect the minor axis 42 of the toroidal structure 44.

Fig. 6 shows a schematic representation of an embodiment of a magnet arrangement 11 according to the invention. The magnet arrangement 11 comprises a magnet coil 30 including a tape 32 comprising a superconducting material. The tape 32 is wound into a toroidal structure 44. An angle between a direction of a magnetic field generated by the magnet coil 30 or magnet arrangement 11 and a main surface 37 of the tape 32 may be substantially constant throughout the toroidal structure 44 and deviate from a zero-degree angle by less than 5°, less than 10° or less than 15°.

In the depicted embodiment, the magnet arrangement 11 comprises a former 33 configured to provide structural support for the magnet coil 30. The former 33 can comprise grooves, channels or receiving surfaces (not shown) configured to accommodate the tape 32. However, in the present embodiment, the former 33 comprises a plain or macroscopically smooth surface.

The magnet coil 30 including the former 33 may comprise the shape of a solid torus. The wound tape 32 (without the former 33) may comprise the shape of a ring torus.

Fig. 6 illustrates a perspective view on a radial section 43 of the magnet coil 30. The radial section 43 depicted in Fig. 6 may coincide with a cutting plane 43 as depicted in Fig. 3. The magnet coil 30 comprises multiple tapes 32a-d arranged around the circumference of the former 33. It is also conceivable that one or more of the elements 32a-d represent turns of the same tape 32 arranged around the circumference of the former 33.

In the depicted embodiment, the tape 32a is wound in such a way that the surface normal vector 46 of the main surface of the tape 32a is essentially orthogonal to a tangent 47 to a surface of the toroidal structure 44 at an origin of the surface normal vector 46.

The individual tapes 32a-d can be spaced from one another, forming gaps 48 between the tapes 32a-d. These gaps 48 can allow for cooling connections, support elements and/or electrical connections to be routed through the gaps 48 between the tapes 32a-d.

Fig. 7 shows a schematic representation of a further embodiment of a magnet arrangement 11 according to the invention. The magnet arrangement 11 comprises a magnet coil 30 including multiple superconducting tapes 32a-d wound into a toroidal structure 44. The radial section 43 depicted in Fig. 7 may coincide with a cutting plane 43 as depicted in the embodiment depicted in Fig. 3.

In the depicted embodiment, the magnet arrangement 11 comprises a former 33. The former 33 can be configured to provide structural support for the tapes 32a-d and/or provide a toroidal shape around which the tapes 32a-d are wound. The former 33 incorporates multiple cooling channels 34. The cooling channels 34 can be integrated into a structure of the former 33. The cooling channels 34 can be configured to circulate a cooling fluid through sections of the former 33, which can aid in precooling the magnet coil 30 and/or maintaining the superconducting state of the tapes 32a-d. In certain embodiments, the cooling fluid can be a cryogen. The cryogen can be cooled via a suitable cryocooler 50 (see Fig. 1) for cryogenic applications.

In a different embodiment, the former 33 comprises a single cooling channel 34, rather than multiple cooling channels 34. The cooling channel 34 can be arbitrarily arranged within the former 33, for example at a centre of the former 33, or close to an outer surface of the former 33.

Additionally or alternatively, the former 33 can be thermally and mechanically connected to a cooling system via a solid thermal conductor 52 (see Fig. 8).

The former 33 can comprise or form part of a precooling circuit configured subject the magnet coil 30 to accelerated cool down in comparison to relying only on the cryocooler 50 of the magnetic resonance device 10. For example, the one or more cooling channels 34 may form a part of the precooling circuit. The precooling circuit may be configured to circulate a coolant or cryogen from an external source through the one or more cooling channels 34 incorporated within the former 33. Suitable coolants for precooling the magnet coil 30 via the precooling circuit may comprise, for example, liquid or gaseous nitrogen or carbon dioxide. After the magnet coil 30 has been precooled to a sufficient degree, the one or more cooling channels 34 can be used to circulate a cryogen through the former 33. The cryogen may be cooled via the cryocooler 50 of the magnetic resonance device 10 (see Fig. 1) or an external cryocooler. Alternative or additionally, the former 33 may be cooled via thermal conduction using a solid thermal conductor 52 according to an embodiment described above.

The former 33 can comprise or consist of a material with a high heat capacity to ensure that the magnet coil 30 remains cold for an extended period of time if the refrigeration is temporarily switched off. However, the former 33 can also comprise other materials. For example, the former 33 can comprise or consist of aluminium, stainless steel, or a composite material, such as glass-reinforced plastic (GRP).

Fig. 8 shows a schematic representation of a further embodiment of a magnet arrangement 11 according to the invention. The magnet arrangement 11 comprises a magnet coil 30 including multiple superconducting tapes 32a, 32b, 32c, and 32d wound into a toroidal structure 44. The radial section 43 depicted in Fig. 8 may coincide with a cutting plane 43 as depicted in the embodiment depicted in Fig. 3.

The magnet coil 30 can be formed by winding a tape 32 comprising a superconducting material into the toroidal structure 44. The magnet coil 30 can comprise multiple strands or turns of high-temperature superconducting tape, shown as elements 32a, 32b, 32c, and 32d (32a-d), wound around a former 33. The former 33 can be configured to provide structural support for the magnet coil 30.

In the depicted example, the former 33 is thermally and mechanically connected to a cooling system via a cooling element such as a solid thermal conductor 52. The solid thermal conductor 52 can comprise or consist of a material with high thermal conductivity, such as a metal (e.g. aluminium, copper, silver, gold, or the like), particularly a high-purity metal. The solid thermal conductor 52 can comprise any suitable shape. For example, the solid thermal conductor 52 can comprise one or more pieces of metal in the shape of a braid, a rod, a plate, a mesh, a rail, or a combination thereof. The solid thermal conductor 52 is thermally and mechanically connected to the cryocooler 50 or a thermal bus connected to the cryocooler 50. The solid thermal conductor 52 may be thermally and mechanically connected to the former 33, but also the cold head 51 of the cryocooler 50, via a form-locking, a force-locking and/or a material connection. For example, the solid thermal conductor 52 may be screwed, bolted, clamped, welded, soldered and/or glued to the former 33. In some embodiments, a highly conductive material, such as indium or a solder material, is arranged between the former 33 and the solid thermal conductor 52.

In the embodiment depicted in Fig. 8, the former 33 comprises receiving surfaces 36 on which the tapes 32a-d are wound. These receiving surfaces 36 can be shaped to accommodate the tapes 32a-d and maintain their desired arrangement and/or orientation within the toroidal structure 44. The receiving surfaces 36 can be formed as grooves, recesses or depressions in a surface of the former 33. However, the receiving surfaces 36 can also protrude or be raised from the surface of the former 33.

In all previously described embodiments, the magnet arrangement 11 may comprise a plurality of magnet coils 30 stacked along a major axis of the toroidal structure 44. This configuration can enable the generation of stronger magnetic fields.

The previously described arrangement of tapes or turns of the tape 32 can allow for an efficient use of superconducting materials, such as high-temperature superconducting materials, while maintaining the desired magnetic field characteristics for applications such as magnetic resonance imaging.

The magnetic resonance device 10 according to the invention can be configured to acquire magnetic resonance data from an object 15 positioned in an imaging region 14 of the magnetic resonance device 10. The magnetic resonance device 10 can include a magnet arrangement 11 according to any one of the previously described magnet arrangements. The magnet coil 30 of the magnet arrangement 11 can be configured to generate a magnetic field strength suitable for magnetic resonance imaging applications. For example, the magnet arrangement 11 can be configured to generate a magnetic field strength in excess of 0.4 Tesla, 1 Tesla, 2 Tesla, or 3 Tesla.

In some examples, the magnet arrangement 11 can comprise a magnet coil 30 including a tape comprising a low-temperature superconducting material instead of a high-temperature superconducting material. Low-temperature superconducting materials can offer certain advantages in terms of cost or performance in some applications.

In certain examples, the tape 32 can comprise magnesium diboride (MgB2) instead of REBCO. Magnesium diboride can offer a balance between the performance of high-temperature superconductors and the cost advantages of low-temperature superconductors in some applications.

Fig. 9 shows a schematic representation of a further embodiment of a magnet arrangement 11 according to the invention. The magnet arrangement 11 comprises a two magnet coils 30a and 30b stacked along the major axis 41 of the toroidal structures 44 of the magnet coils 30a and 30b. The first magnet coil 30a may comprise a first tape 32a wound into a toroidal structure 44, and the second magnet coil 30b may comprise a second tape 32b wound into a toroidal structure 44. In stacking a plurality of magnet coils 30 along the major axis 41 of the toroidal structure 44, a stronger magnetic field and/or a more uniform magnetic field distribution within the imaging region 14 of the magnetic resonance device 10 may be achieved.

In the depicted embodiment, the first tape 32a and the second tape 32b are wound in such a way that middle sections of the first tape and the second tape are arranged at a surface of the toroidal structure 44 facing towards the major axis 41 of the toroidal structure 44 (not shown). The distal ends 32a.1, 32a.2, 32b.1 and 32b.2 of the first tape 32a and the second tape 32b can be arranged on a surface of the toroidal structure 44 facing away from the major axis 41 of the toroidal structure 44.

The middle sections of the one or more tapes 32 can be electrically connected via a connecting element 38.1. The distal end 32a.2 of the first tape 32a can be electrically connected to the distal end 32b.2 via a connecting element 38.2 so as to form double toroid coil. An unconnected distal end 32a.1 of the first magnet coil 32a and an unconnected distal end 32b.1 of the second magnet coil 30b may act as an input lead and an output lead arranged on a surface of the toroidal structures 44 facing away from the major axis 41 of the double toroid coil.

Fig. 10 shows a schematic representation of a further embodiment of a magnet arrangement 11 according to the invention. The magnet arrangement 11 comprises a two magnet coils 30a and 30b stacked along the major axis 41 of the toroidal structures 44 of the magnet coils 30a and 30b. The first magnet coil 30a comprises a first tape 32a wound into a toroidal structure 44, and the second magnet coil 30b comprises a second tape 32b wound into a toroidal structure 44. In stacking a plurality of magnet coils 30 along the major axis 41 of the toroidal structure 44, a stronger magnetic field and/or a more uniform magnetic field distribution within the imaging region 14 of the magnetic resonance device 10 may be achieved.

In the depicted embodiment, the first tape 32a and the second tape 32b are wound in such a way that the distal ends 32a.1 and 32a.2 of the first tape 32a, and the distal ends 32b.1 and 32b.2 of the second tape 32b are be arranged on a surface of the toroidal structure 44 facing away from the major axis 41 of the toroidal structure 44. In other embodiments, one more of the distal ends 32a.1, 32a.2, 32b.1, and 32b.2 can also be arranged on a surface facing towards the major axis 41 of the toroidal structure 44. Preferably, pairs of the distal ends of the first tape 32a and the second tape 32b are arranged in a corresponding manner. For example, corresponding distal ends of the first tape 32a and the second tape 32b are arranged either at a surface facing away from the major axis 41, or at a surface facing towards the major axis 41 of the toroidal structure 44.

The distal end 32a.2 of the first tape 32a is electrically connected to the corresponding distal end 32b.2 of the second tape 32b via the connecting element 38.2. In the depicted embodiment, the unconnected distal end 32a.1 of the first magnet coil 32a and the unconnected distal end 32b.1 of the second magnet coil 30b act as an input lead and an output lead arranged on a surface of the toroidal structures 44 facing away from the major axis 41 of the double toroid coil.

In the embodiment illustrated in Fig. 10, the first tape 32a and the second tape 32b are connected in series. Of course, more than two magnet coils 30a and 30b, may be connected in similar manner. For example, the magnet arrangement 11 may comprise at least three, four, five or six magnet coils 30 stacked and connected in a similar manner as shown in Fig. 10.

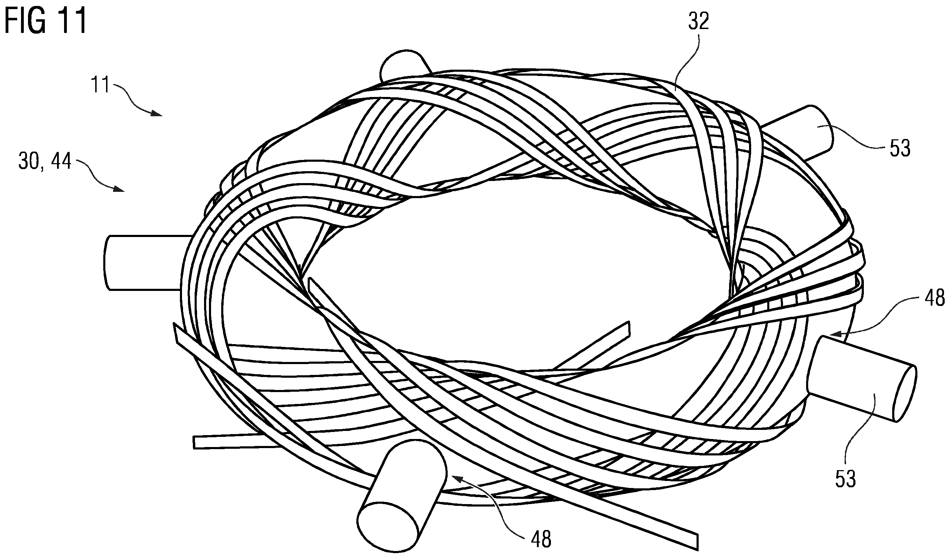

Fig. 11 shows a schematic representation of a further embodiment of a magnet arrangement 11 according to the invention. The magnet arrangement 11 comprises a magnet coil 30 including a tape 32 comprising a superconducting material. The tape 32 is wound into a toroidal structure 44. In the depicted embodiment, the tape 32 is helically wound around the minor axis 42 of the toroidal structure 44 (see Fig. 2).

The magnet coil 30 depicted in Fig. 11 comprises four individual tapes 32 wound into the toroidal structure 44. The tapes 32 can be electrically connected in series to improve the homogeneity of the magnetic field generated by the magnet coil 30. However, the tapes 32 may also be electrically connected in parallel to increase a current in the magnet coil 30 and/or provide some tolerance to damage to individual tapes. The tapes 32 are wound over each other in multiple layers. According to an embodiment, the former can comprise receiving surfaces or grooves (not shown) arranged in different radial planes or radial sections allowing the tape or multiple tapes to be wound over each other in multiple layers without contacting each other.

In the embodiment illustrated in Fig. 11, the tapes 32 are wound in such a way to provide one or more gaps 48. The gaps 48 are configured to allow for cooling connections, support elements 53 and/or electrical connections to be routed through the gaps 48 between the tapes 32. The gaps 48 may be defined by the winding pattern of the tapes 32. The gaps 48 may provide a localized separation of the tapes 32 (or of the turns of one tape 32) and/or a localized void of the superconducting material.

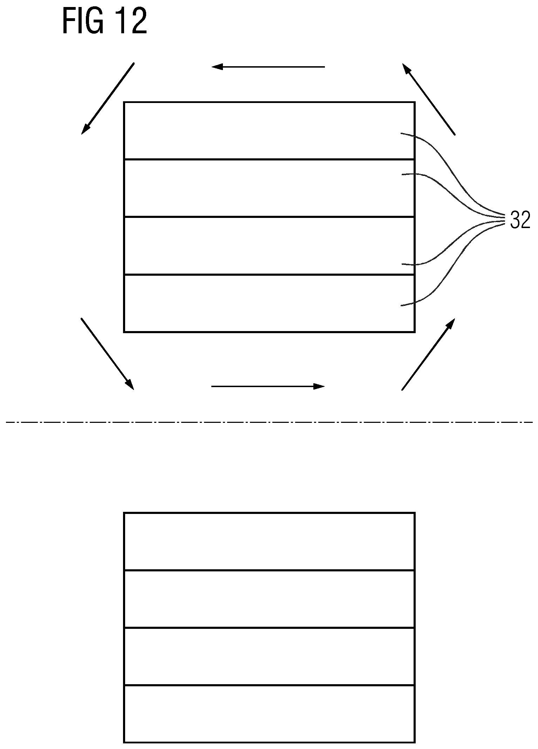

Fig. 12 shows an embodiment of a conventional cylindrical magnet coil which can be used in a single pancake or double pancake configuration. The tape 32 is wound on top of itself in a radial direction to create a coil with multiple turns.

In conventional magnet coils and magnet arrangements comprising conventional magnet coils, the local direction of the magnetic field (indicated by arrows) can be angled with respect to a main surface of the tape 32, especially at the corners of the rectangular cross-section of the tapes 32 depicted in Fig. 12. This angular dependence typically leads to inefficient use of the superconducting material, resulting in conservative designs that may not fully utilize the potential of the superconducting tape throughout an entire magnet arrangement.

The schematic representations depicted in the figures do not represent any scale or size relationships.

The methods and devices described in detail above are merely exemplary embodiments which can be modified in a variety of ways by those skilled in the art without departing from the scope of the invention. Particularly, individual embodiments may be extended by or combined with features of other embodiments if not explicitly stated otherwise.

Furthermore, the use of the indefinite articles "a" or "an" does not preclude that individual features in question can also be present multiple times. Likewise, the terms "unit" and "element" do not preclude that the components in question consist of several interacting sub-components which can also be spatially distributed if necessary.

## Claims

1. A magnet arrangement (11), comprising:
a magnet coil (30) including a tape (32) comprising a superconducting material,
wherein the tape (32) is wound into a toroidal structure (44), and
wherein an angle between a direction of a magnetic field generated by the magnet coil (30) and a main surface (37) of the tape (32) is substantially constant throughout the toroidal structure (44) when the magnet coil (30) is in an operating state.

2. The magnet arrangement (11) of claim 1, wherein the tape (32) is helically wound around a minor axis (42) of the toroidal structure (44).

3. The magnet arrangement (11) of claim 1 or 2, wherein the tape (32) is wound in such a way that the direction of the magnetic field generated by the magnet coil (30) is oriented substantially in parallel to the main surface (37) of the tape (32) throughout the toroidal structure (44).

4. The magnet arrangement (11) of any one of claims 1 to 3, comprising at least one further tape (32b) wound into the toroidal structure (44).

5. The magnet arrangement (11) of any one of claims 1 to 4, comprising a former (33) configured to provide structural support for the magnet coil (30).

6. The magnet arrangement (11) of claim 5, wherein the former (33) is configured to accommodate a cooling fluid to cool the magnet coil (30) and/or wherein the former (33) is thermally and mechanically connected to a cooling system via a solid thermal conductor.

7. The magnet arrangement (11) of any one of claims 1 to 6, wherein the tape (32) comprises a high-temperature superconducting material, for example a rare earth barium copper oxide (REBCO) material.

8. The magnet arrangement (11) of any one of claims 1 to 7, comprising a plurality of magnet coils (30) stacked along a major axis (41) of the toroidal structure (44).

9. The magnet arrangement (11) of any one of claims 1 to 8, comprising at least two tapes (32a; 32b) or at least two turns of the tape (32) wound in a toroidal structure (44), wherein the at least two tapes (32a; 32b) or the at least two turns of the tape (32) are separated by a gap (48) and wherein a cooling connection, a support element (53) and/or an electrical connection of the at least two tapes (32a; 32b) or the tape (32) are routed through the gap (48) between the at least two tapes (32a; 32b) or the at least two turns of the tape (32).

10. The magnet arrangement (11) of any one of claims 1 to 8, wherein the tape (32) is wound in such a way that a middle section of the tape (32) is arranged at a surface of the toroidal structure (44) facing towards the major axis (41) of the toroidal structure (44), and distal ends of the tape (32) are arranged on a surface of the toroidal structure (44) facing away from the major axis (41) of the toroidal structure (44).

11. A method of manufacturing a magnet arrangement (11), the method comprising: forming a magnet coil (30) by winding a tape (32) comprising a superconducting material into a toroidal structure (44), wherein the tape (32) is wound in such a way that a surface normal vector (46) of a main surface (37) of the tape (32) rotates around a minor axis (42) of the toroidal structure (44) during a process of winding.

12. The method of claim 11, wherein the tape (32) is helically wound around the minor axis (42) of the toroidal structure (44).

13. A magnetic resonance device (10), configured to acquire magnetic resonance data from an object (15) positioned in an imaging region (14) of the magnetic resonance device (10), the magnetic resonance device (10) comprising a magnet arrangement (11) according to any one of claims 1 to 10.

14. The magnetic resonance device (10) of claim 13, comprising a magnet arrangement (11) of claim 5 or 6, further including a cooling system configured to cool the former (33).

15. The magnetic resonance device (10) of claim 13 or 14, wherein the magnet arrangement (11) is configured to generate a magnetic field strength suitable for magnetic resonance imaging applications.
